# EUROPEAN PATENT APPLICATION

(11) **EP 4 827 252 A1**
(43) Date of publication of application: **21.10.2026**
(21) Application number: 25170819.4
(22) Date of filing: 15.04.2025
(51) Int. Cl.: H05K 3/40, H05K 3/46, H05K 1/11, H05K 1/18, H05K 1/03, H01B 7/08

(54) **FLAT FLEXIBLE CABLE**

(71) Applicant: Parlex Pacific Limited, Shatin, New Territories Hong Kong (HK)
(72) Inventor: Linfield, Calvin John, Ryde (GB); Roy, Jean-Francois Leo, Jouarre (FR); Dean, Steven Eric, Intervale (US)
(74) Representative: Doherty, William

(57) **Abstract**

A flat flexible cable (10) is provided for interconnecting electrical components. There is a cable body (12) including a plurality of signal conductors (14) a tab conductor (16) spaced apart from the plurality of signal conductors (14), and an insulation layer (18) over the plurality of signal conductors (14) and the tab conductor (18). Also provided is a plurality of bridge conductors (26) on the insulation layer (18), each of the plurality bridge conductors (26) being in electrical communication with the tab conductor (18) through the insulation layer (18) and in electrical communication with a signal conductor (14) of the plurality of signal conductors (14) through the insulation layer (18). An electrical connector formed from such a flat flexible cable (10) is also provided.

## Description

The present invention relates to a flat flexible cable particularly but not exclusively for electrically connecting battery cells of a battery system, more particularly within an automotive context. The invention further relates to a method of forming an electrical connector for interconnecting electrical components. The invention further relates to an electrical connector for interconnecting electrical components, and to a battery management system comprising such an electrical connector.

A traditional electrical connector for a battery management system, such as that of an electric vehicle, comprises a flexible printed circuit, which uses an etching process to form, or flexible die cut product, which uses a milling process, which can have a length of more than 2 metres, to electrically interconnect the controller of the battery management system to the battery cells of the vehicle.

Due to the branching structure of the various signal lines from the battery management system to the battery cells, there is a large amount of unused space on the substrate of a flexible printed circuit. This leads to a large amount of wasted substrate, as it is cut from the flexible printed circuit and discarded. Given that the substrate is typically a polyimide, this becomes prohibitively expensive.

Additionally, due to the scale of the electrical connector required, manufacturing becomes challenging. Manufacture of a flexible printed circuit longer than 1 meter is challenging. Furthermore, automation of assembly is difficult, and packaging and transportation of the electrical connector is also an issue.

It is an object of the present invention to reduce or substantially obviate the aforementioned problems by constructing long electrical connectors from alternative materials.

According to a first aspect of the invention, there is provided a flat flexible cable for interconnecting electrical components, the flat flexible cable comprising: a cable body including: a plurality of signal conductors; a tab conductor spaced apart from the plurality of signal conductors; and an insulation layer over the plurality of signal conductors and the tab conductor; and characterized by a plurality of bridge conductors provided on the insulation layer, each of the plurality bridge conductors being in electrical communication with the tab conductor through the insulation layer and in electrical communication with a signal conductor of the plurality of signal conductors through the insulation layer.

Such a flat flexible cable has a robust and compact construction, and can be spooled onto a reel for reel-to-reel processing. This provides many advantages over flexible printed circuits or milled arrangements, which are more cumbersome to manufacture, package, and install by comparison. The presence of the tab conductor also avoids the need to separately weld tabs to any electrical connector products. The flat flexible cable is also highly fungible, allowing a single cable to be exchanged into different projects.

Optionally, two said tab conductors may be provided, spaced apart either side of the plurality of signal conductors.

A more space-efficient electrical connector is achieved if there are conductive tabs available on both sides of the electrical connector, since a more efficient packing of electrical components such as battery cells can be achieved. Two, or indeed, more than two tab conductors, can achieve this.

In one embodiment, the flat flexible cable may be provided as a reel.

Reeled cables are more economical to transport, and more efficient to process via reel-to-reel processes than other types of electrical connector.

The flat flexible cable may further comprise a plurality of safety components respectively in electrical communication with the plurality of bridge conductors. Optionally, the safety component may comprise a fuse or thermistor.

The provision of the bridge conductors on the insulation surface allows for a different construction method to be provided. Safety components can be added, since dedicated gaps can be left on the surface where interconnecting safety components can be installed. This allows for easy mass-manufacture of the flat flexible cable, and then final assembly of the additional components can be performed onsite.

The tab conductor may have a greater width and/or conductive-material volume than any of the plurality of signal conductors.

The tab conductor can be designed for most effective capacity for being connected to onward electrical components or a busbar, for instance, by laser welding.

Preferably, each of the plurality of bridge conductors may be provided as a conductive trace on the insulation layer.

A conductive trace may allow for the additional conductive material to be allowed whilst still allowing for spooling of the flat flexible cable.

According to a second aspect of the invention, there is provide a method of forming an electrical connector for interconnecting electrical components, the method comprising the steps of: a] providing a flat flexible cable having a cable body including a plurality of signal conductors, a tab conductor, and an insulation layer over the plurality of signal conductors and the tab conductor; characterized by b] applying a plurality of bridge conductors on the insulation layer, each of the plurality of bridge conductors being in electrical communication with the tab conductor through the insulation layer and in electrical communication with a signal conductor of the plurality of signal conductors through the insulation layer; and c] singulating the tab conductor to create a conductive tab which can be electrically connected to an electrical component.

There are several advantages associated with the processing method for forming an electrical connector via this method. Firstly, there is a much-reduced material waste compared with assembling the electrical connector via a flexible printed circuit method. The process is also more environmentally friendly, requiring no chemical etching steps. Furthermore, there is no need to weld additional tabs in place; the presence of dedicated tab conductors which can be exposed from the flat flexible cable eliminates this step.

The method may further comprise a step prior to step b] of removing part of the insulation layer at the plurality of signal conductors and at the tab conductor at the locations where the electrical communication with the plurality of bridge conductors will be made during step b].

Exposing the conductors allows for the printing process of the bridge conductors to be performed without needing to perform chemical etching, improvement the environmental credentials of the electrical conductor formed.

During step b], the plurality of bridge conductors may be applied to the insulation layer as a printed conductive trace.

Printing of the conductive traces may improve the speed of manufacture of the electrical conductors.

The method may further comprise a step b](i) following step b] and prior to step c] of applying a further insulation layer over the plurality of bridge conductors.

Additional insulation may be desirable over the bridge conductors to protect any connections between the tab and signal conductors.

Optionally, the method may further comprise a step prior to step c] of removing part of the insulation layer at the tab conductor where the conductive tab will be created.

Exposing the conductor prior to application of the bridge conductor is the simplest means by which an electrical connection can be achieved.

Advantageously, step b] may be performed as a reel-to-reel process.

A reel-to-reel process may be performed much faster than an equivalent chemical etching process associated with traditional printed circuit board manufacture. Reels can also be transported more efficiently and economically than other means, and automation of installation is improved for reel-based technologies.

According to a third aspect of the invention, there is provided an electrical connector for interconnecting electrical components, the electrical connector comprising: a flat flexible cable comprising: a cable body including: a plurality of signal conductors; a plurality of conductive tabs spaced apart from the plurality of signal conductors; and an insulation layer over at least the plurality of signal conductors; and characterized by a plurality of bridge conductors provided on the insulation layer, each of the plurality of bridge conductors being in electrical communication with one of the plurality of conductive tabs through the insulation layer and in electrical communication with the one of the plurality of signal conductors through the insulation layer.

Electrical connectors of this type can be formed in a manner which allows for reel-to-reel processing, since they remain largely flat after printing of the bridge conductors. This provides for a highly fungible product, which can be cut to the required size by the installing party with ease.

According to a fourth aspect of the invention, there is provided a battery management system comprising an electrical connector in accordance with the third aspect of the invention.

The present invention is highly suited for use with a battery management system, where electrical components may be quite spaced apart from one another. The present electrical connector can be formed having an extending conductor, which can be formed more easily than a flexible printed circuit.

Reference will now be made by way of example only to the accompanying drawings, in which:
Figure 1A shows a plan view of part of a first embodiment of flat flexible cable in accordance with the first aspect of the invention;
Figure 1B shows a cross-sectional representation through line A-A of Figure 1A;
Figure 2 shows a partial plan view of a second embodiment of flat flexible cable in accordance with the first aspect of the invention;
Figure 3 shows an isometric representation of a precursor flat flexible cable prior to being formed into the flat flexible cable of Figure 2;
Figure 4 shows an isometric representation of the precursor flat flexible cable of Figure 3, having some of the insulation layer removed to form contact portions of the signal and tab conductors;
Figure 5 shows an isometric representation of a flat flexible cable in accordance with the first aspect of the invention, formed by applying a plurality of bridge conductors to the precursor flat flexible cable of Figure 4;
Figure 6 shows an isometric representation of the flat flexible cable of Figure 5, including a further insulation layer over the plurality of bridge conductors;
Figure 7 shows an isometric representation of the flat flexible cable of Figure 6, further including printed indicator markings on the surface thereof;
Figure 8 shows an isometric representation of the flat flexible cable of Figure 7, following removal of insulation around the conductive tabs of the flat flexible cable;
Figure 9 shows an isometric representation of the flat flexible cable of Figure 8, following formation of the final profile of an electrical connector in accordance with the third aspect of the invention from the flat flexible cable;
Figure 10 shows an isometric representation of the flat flexible cable of Figure 9, further including applied safety components onto the surface of the flat flexible cable;
Figure 11 shows an isometric representation of part of an electrical connector in accordance with the third aspect of the invention, formed from the flat flexible cable of Figure 10; and
Figure 12 shows an isometric representation of the electrical connector of Figure 11.

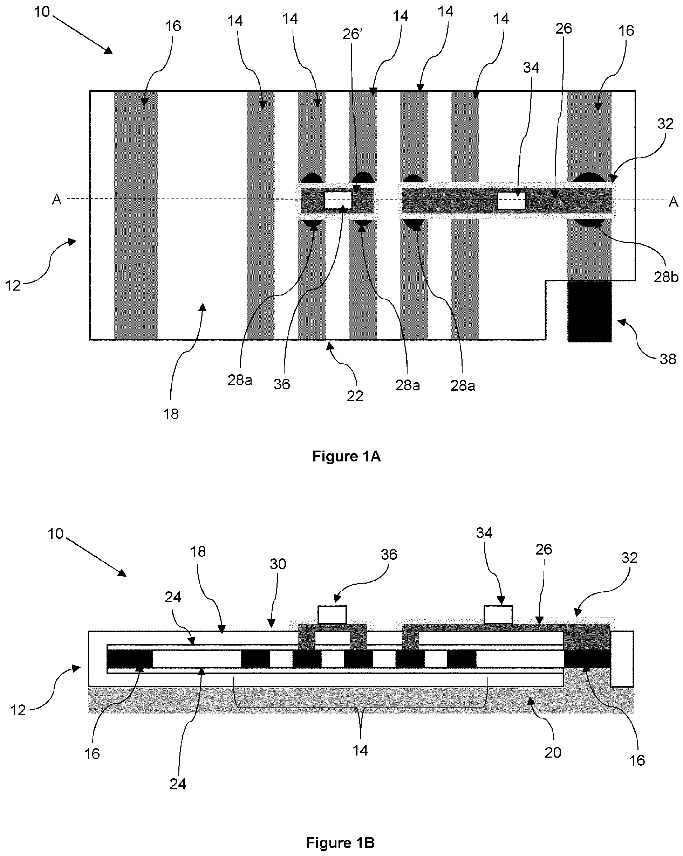

Referring firstly to Figures 1A and 1B, there is shown an end of a flat flexible cable, referenced globally at 10, and which is suitable for use in the formation of an electrical connector for, in particular, battery management systems, and more specifically, battery management systems in the automotive industry. However, it will be apparent that the electrical connector formed in accordance with the present invention may have a wide variety of possible uses.

The flat flexible cable 10 comprises a cable body 12 including a plurality of signal conductors 14, at least one, and more preferably two, tab conductors 16 spaced apart from the plurality of signal conductors 14, and an insulation layer 18 over the plurality of signal conductors 14 and the tab conductor 16.

The term signal conductor 14 here refers to a conductive member, typically a copper or similarly conductive metal, preferably as a trace, which runs through the flat flexible cable 10. This will usually be provided for the purpose of direct connection to a controller or processor of the electrical system with which the flat flexible cable 10 is being used. As such, the signal conductor 14 will likely be suited towards transmission of low-voltage control signals.

The signal conductors 14, which could also be referred to as inside conductors based on their location on the cable body 12, may be chosen to have the same pitch so as to match with a chosen interconnection to, for example, the battery management system.

The term tab conductor 16 here refers to a conductive member which would not be directly engaged with the controller. Instead, it forms the connection to the electrical system being connected by the flat flexible cable 10, usually via a busbar 20 intermediate the controlled electrical component. The tab conductor 16 may be formed from copper, nickel, or a similarly conductive metal, preferably as a trace, which also runs through the flat flexible cable 10. The tab conductor 16 is preferably larger, either in width or depth in the flat flexible cable, as it may be exposed to higher voltages and/or currents than the signal conductors 14.

The tab conductors 16 may be chosen with a different pitch, material, material width, and/or material thickness so as to be compatible with laser welding onto a battery cell, similar electrical component, or onto a busbar.

The insulation layer 18 surrounds all of the signal and tab conductors 14, 16, prior to any processing to form a subsequent electrical connector, with only exposed contact portions typically being present at either end 22 of the cable body 12.

A typical flat flexible cable in the art would only have a plurality of signal conductors inside an insulating cable body. Flat flexible cables having additional tab conductors are not known.

The insulation layer 18 may be connected in place to the plurality of signal conductors 14 and the tab conductors 16 via one or more adhesive layers 24. Figure 1B illustrates this. It is noted that, for simplicity, the insulation layer 18 is illustrated as a continuous layer enveloping the signal and tab conductors 14, 16, but it may be possible to provide upper and lower insulation layers which are secured together around the signal and tab conductors 14, 16 during manufacture.

The purpose of the flat flexible cable 10 is to allow electrical signals to be transferred from the signal conductors 14, and thus from the controller, to the tab conductors 16, and thus electrical components of the system. However, the signal conductors 14 and tab conductors 16 are spaced apart from one another, and therefore further electrical connections must be made.

To this end, there is also provided a bridge conductor 26 the insulation layer 18, with the bridge conductor 26 being in electrical communication with the tab conductor 16 through the insulation layer 18 and being in electrical communication with a signal conductor 14 of the plurality of signal conductors 14 through the insulation layer 18.

Vias 28a, 28b through the insulation layer 18 are indicated in Figure 1A. The vias 28a, 28b expose the underlying signal conductors 14 and tab conductors 16, allowing for electrical connections to be made. The vias 28a, 28b are here made by etching through the insulation layer 18, which may be formed from polyethylene terephthalate (PET) or a similar dielectric medium.

The bridge conductor 26 extends between the vias 28a, 28b to interconnect a signal conductor 14 and a tab conductor 16. The arrangement of Figures 1A and 1B show only one bridge conductor 26, but it will be apparent that a plurality of said bridge conductors 26 would be provided in practice.

The bridge conductor 26 may be provided as a conductive trace on the surface 30 of the insulation layer 18, and may be coated with a further insulation layer 32 to prevent exposed conductive portions from being accessed.

Safety components may be provided on the bridge conductor 26. For example, there may be a fuse 34, and/or there may be a thermistor 36, such as a negative-temperature co-efficient (NTC) thermistor provided, thus providing thermal and electrical surge protection for the signal conductors 14, and by extension, controller. Safety components can be created via an additive process such as printed electronics techniques. In particular, this may be appropriate for the thermistor 36. The fuse 34 may be provided via surface mount technology (SMT). The thermistor 36 may not necessarily be provided in connection with the bridge conductor 26, and instead, may interconnect different components, such as more than one signal conductor 14. As shown in the depicted embodiment, the thermistor 36 may be provided positioned on a further bridge connector 26' which interconnects two said signal conductors 14.

A conductive tab 38 of the tab conductor 16 remains exposed in the embodiment of Figure 1A. Once the flat flexible cable 10 has been processed to singulate the conductive tab 38 from the main tab conductor 16, as will be described in detail below, the conductive tab 38 can be connected to a busbar 20 or electrical component, for example, by soldering.

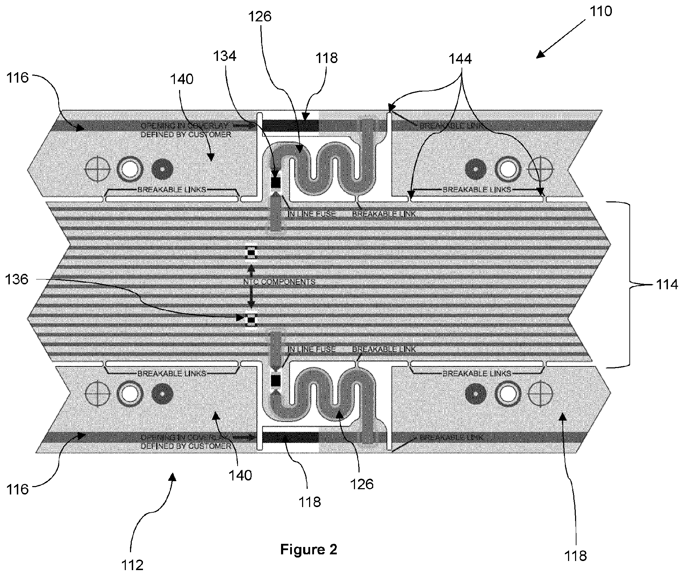

Figure 2 shows a second embodiment of a flat flexible cable, referenced globally at 110. Identical or similar features of the first described embodiment will be referenced using identical or similar reference numerals, and further detailed description is omitted for brevity.

The flat flexible cable 110 has a cable body 112, a plurality of signal conductors 114, and the two tab conductors 116. From the outset, the insulation layer 118 fully covers the signal conductors 114 and tab conductors 116. The bridge conductors 126 have been isolated, with removable portions 140 of the cable body 112 being provided for removal to form the final electrical connector 142 shape. Breakable links 144 are provided to allow for ease of removal at the point of installation, whilst also protecting the conductive tabs 138 in transit.

Breakable links 144 are provided as frangible portions of the cable body 112 separating the removable portions 140 of the cable body 112 from the substrate which forms the electrical connector 142. The removable portions 140 are dimensioned so as to allow for sufficient movement for the conductive tabs 138 once the breakable links 144 are severed, prior to installation.

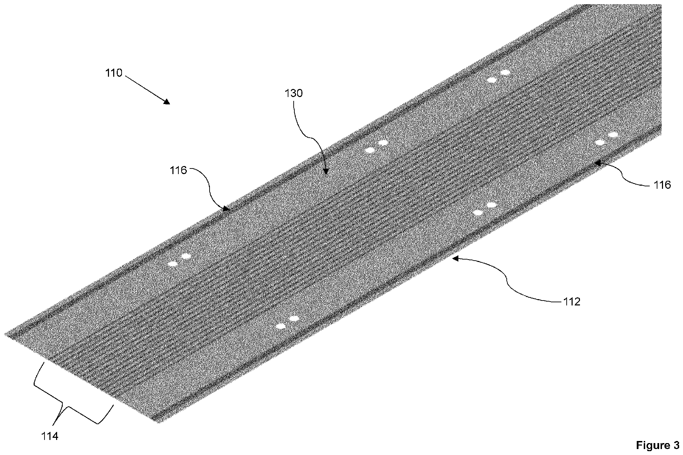

Figures 3 to 12 illustrate the sequential preparation of the flat flexible conductor 110, and formation into an electrical connector 142 suitable for use in an electrical system such as a battery management system.

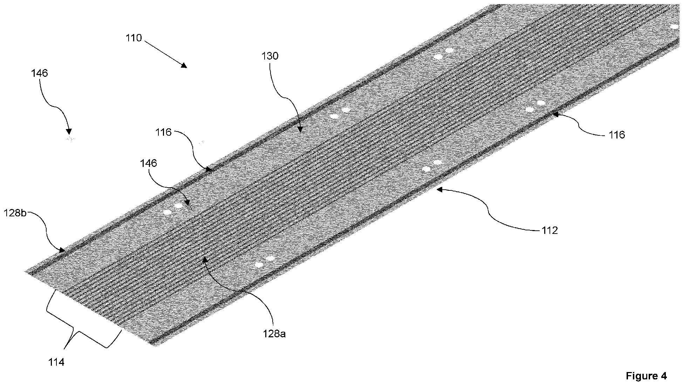

In Figure 4, an etching process occurs, removing a part 146 of the insulation layer 118 to form the vias 128a, 128b at the signal conductors 114 and tab conductors 116 respectively. This is described as being performed by etching, either mechanically or chemically, or could be performed by, for example, precise laser cutting.

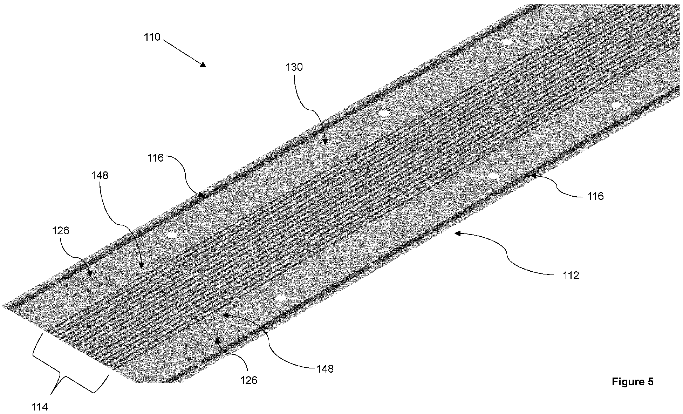

In Figure 5, the bridge conductors 126 are applied as printed conductive traces onto the surface 130 of the insulation layer 118, interconnecting the vias 128a, 128b and thus forming the basis of the electrical interconnection between the signal conductors 114 and the tab conductors 116. In the embodiment shown, the bridge conductors 126 are formed as a silver trace, but other conductive metals could be used.

The bridge conductors 126 may be printed to the flat flexible cable 110 in a reel-to-reel process. In other words, the flat flexible cable 110 may be provided spooled onto a reel, and then as it is unspooled and respooled onto another reel, the printing of the bridge conductors 126 is applied.

The bridge conductors 126 may be provided with strategic gaps 148 which are designed to allow the safety components to be installed. The bridge conductors 126 themselves may have an undulating profile to assist with strengthening the bridge formed once the flat flexible cable 110 is cut to size, and also to assist with the dissipation of heat.

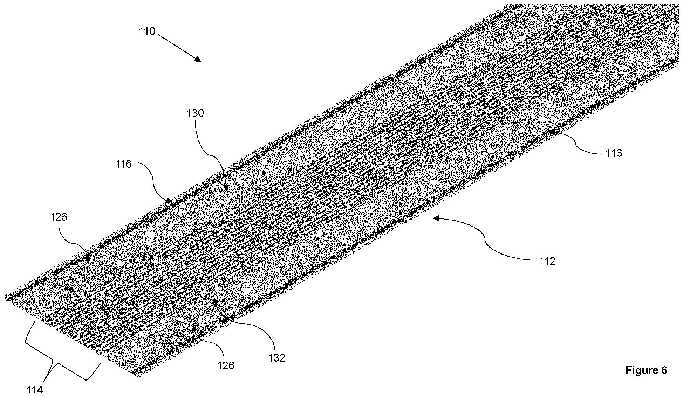

Figure 6 shows the overlaying of the further insulation layer 132 onto the bridge conductors 126. Again, this can be applied via a reel-to-reel printing process. The bridge conductors 126 are partially exposed at the strategic gaps 148 so as to allow for the safety components to be inserted thereafter.

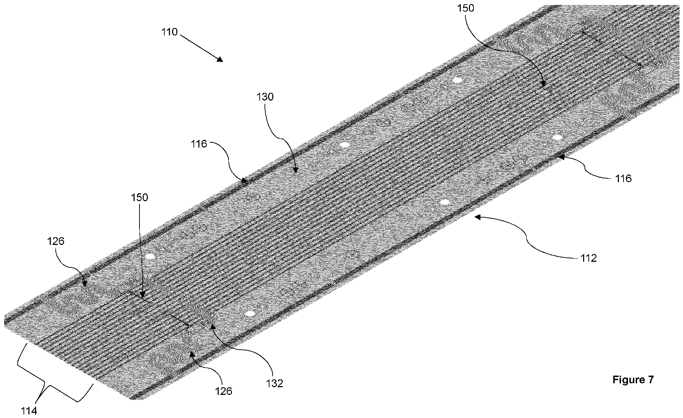

Figure 7 illustrates the surface indicia 150 which may be applied onto the surface 130 of the insulation layer 118. This may assist with identification of the locations where the safety components are to be installed, either for manual installation, or for automated installation performed via visual recognition of the location.

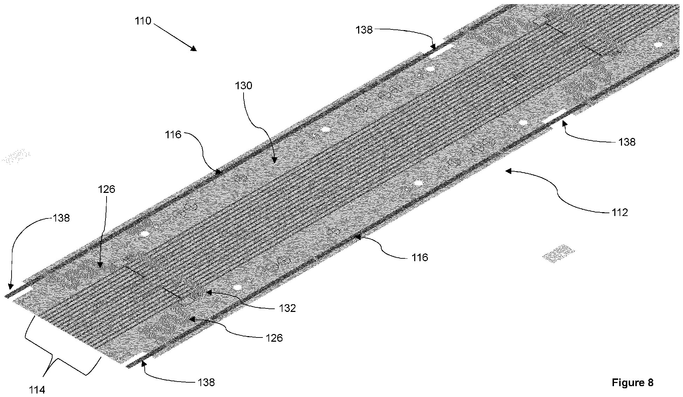

Conductive tabs 138 are then exposed by further removal of insulation layer 118 at the appropriate location. This is illustrated in Figure 8. Notably, at this point in the process, the conductive tabs 138 of any given tab conductor 116 remain electrically connected, since the conductive tabs 138 are formed from the unbroken tab conductor 116. In the depicted embodiment, the conductive tabs 138 therefore all run in parallel with one another, and conductive tabs 138 formed from a single tab conductor 116 are co-axial.

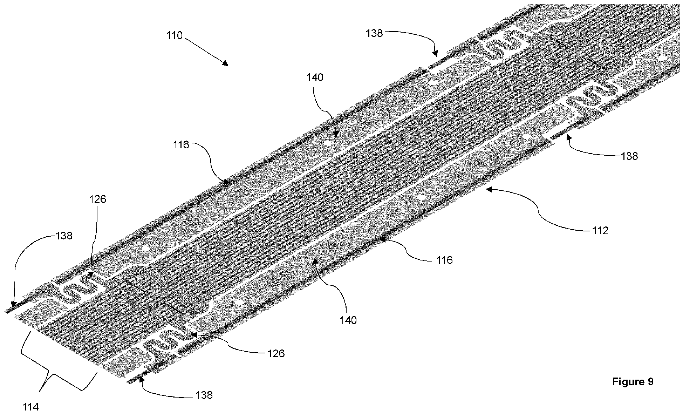

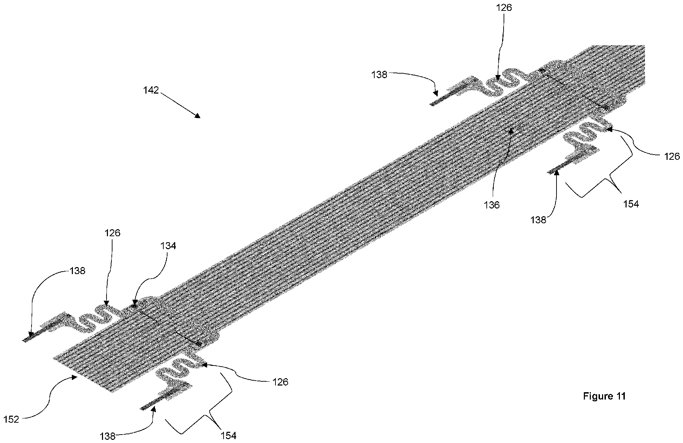

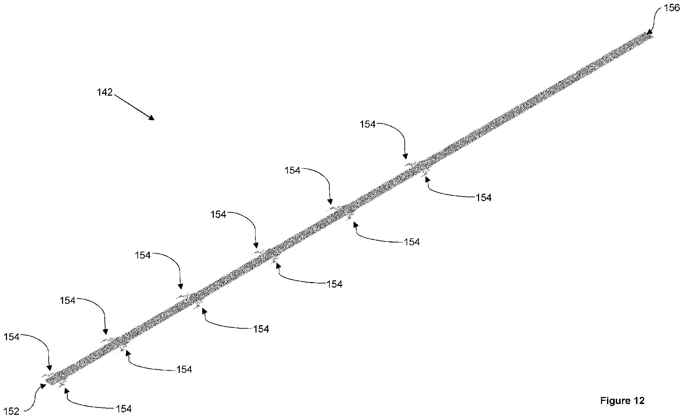

The process of singulation of the conductive tabs 138 is shown in Figure 9. The outline of the final electrical connector 142 and shown in Figures 11 and 12 is cut from the flat flexible cable 110, and this severs the connection between the adjacent conductive tabs 138 of the tab conductor 116. This process would typically be performed by precise laser cutting, particularly since the profile of the bridge conductors 126 is carefully followed.

Whilst the conductive tabs 138 are exposed after printing of the bridge conductors 126, within the depicted process, it is noted that there is no specific sequential requirement, and the embodiment indicated is for illustrative purposes only.

Sequentially, the critical steps are that the signal and/or tab conductors 114, 116 must be exposed before the application of the bridge conductors 126 onto the insulation layer 118, and the further insulation layer 132 can only be added after the bridge conductors 126 have been applied. Otherwise, the remaining steps may be performed in any appropriate sequence which is efficient for the manufacturer.

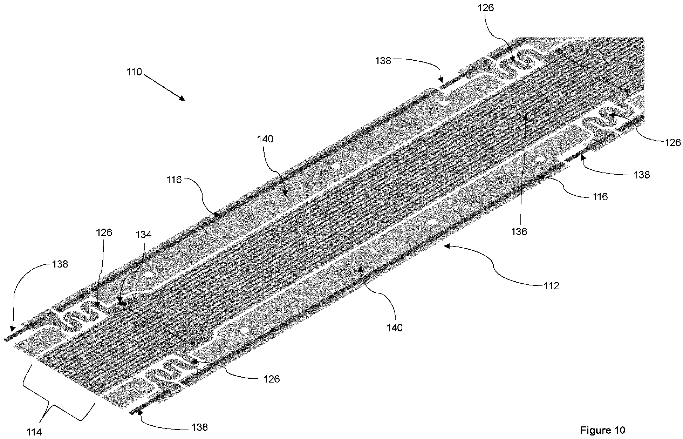

Figure 10 shows the installation of the fuses 134 and thermistors 136 onto the flat flexible cable 110. This is the point at which reel-to-reel installation ceases to be viable, since the safety components have a height which is prohibitive to spooling. The safety components can be soldered or otherwise electrically secured into position on the flat flexible cable 110.

Figures 11 and 12 show the completed electrical connector 142. A main section 152 of the cable body 112 has been reduced to the region containing the signal conductors 114, with the bridge conductors 126 and conductive tabs 138 forming flexible side portions 154 which have a greater positional tolerance for connecting to a busbar or electrical component due to the thinner construction relative to the main section 152.

Figure 12 shows the scale of a typical electrical connector 142 for a battery management system. The electrical connector 142 might have a length of between 1 and 3 metres, extending through the chassis of a vehicle from the battery management system to the battery cells of an electric vehicle.

Such an electrical connector 142 spans from a controller end 156 which will interface with a controller of the battery management system, with the conductive tabs 138 interfacing directly or indirectly with battery cells of a battery system controlled by the battery management system.

Whilst the arrangement illustrated in the present invention shows an entirely linear set of conductors as part of the flat flexible cable, a different construction of flat flexible cable could be provided in which non-linear conductors are present. This may provide alternative solutions to circuit design, but may make reel-to-reel manufacturing more complex.

Furthermore, whilst the tab conductors of the present invention are shown at the lateral edges of the flat flexible cable, in some applications, it may be desirable to have the tab conductors positioned in between the signal conductors. The positioning of the tab conductor or signal conductors is therefore selected according to the requirements of the electrical connector to be produced.

It is therefore possible to provide a flat flexible cable which is highly fungible and therefore usable in many different electrical systems. The flat flexible cable has a much simpler and more robust construction than equivalent flexible printed circuits or die cut boards, and can be used in reel-to-reel processing. Long and stable electrical connectors which integral conductive tabs can thus be formed, further simplifying installation of the electrical connector compared with flexible printed circuits.

The words 'comprises/comprising' and the words 'having/including' when used herein with reference to the present invention are used to specify the presence of stated features, integers, steps, or components, but do not preclude the presence or addition of one or more other features, integers, steps, components, or groups thereof.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable sub-combination.

The embodiments described above are provided by way of example only, and various changes and modifications will be apparent to persons skilled in the art without departing from the scope of the present invention as defined by the appended claims.

## Claims

1. A flat flexible cable (10; 110) for interconnecting electrical components, the flat flexible cable (10; 110) comprising:
a cable body (12; 112) including:
a plurality of signal conductors (14; 114);
a tab conductor (16; 116) spaced apart from the plurality of signal conductors (14; 114); and
an insulation layer (18; 118) over the plurality of signal conductors (14; 114) and the tab conductor (16; 116); and
**characterized by** a plurality of bridge conductors (26; 126) provided on the insulation layer (18; 118), each of the plurality of bridge conductors (26; 126) being in electrical communication with the tab conductor (16; 116) through the insulation layer (18; 118) and in electrical communication with a signal conductor (14; 114) of the plurality of signal conductors (14; 114) through the insulation layer (18; 118).

2. A flat flexible cable (10; 110) as claimed in claim 1, wherein two said tab conductors (16; 116) are provided, spaced apart either side of the plurality of signal conductors (14; 114).

3. A flat flexible cable (10; 110) as claimed in claim 1 or claim 2, wherein the flat flexible cable (10; 110) is provided as a reel.

4. A flat flexible cable (10; 110) as claimed in any one of the preceding claims, further comprising a plurality of safety components respectively in electrical communication with the plurality of bridge conductors (26; 126).

5. A flat flexible cable (10; 110) as claimed in claim 4, wherein the safety component comprises a fuse (34; 134) or thermistor (36; 136).

6. A flat flexible cable (10; 110) as claimed in any one of the preceding claims, wherein the tab conductor (16; 116) has a greater width and/or conductive-material volume than any of the plurality of signal conductors (14; 114).

7. A flat flexible cable (10; 110) as claimed in any one of the preceding claims, wherein each of the plurality of bridge conductors (26; 126) is provided as a conductive trace on the insulation layer (18; 118).

8. A method of forming an electrical connector (142) for interconnecting electrical components, the method comprising the steps of:
a] providing a flat flexible cable (10; 110) having a cable body (12; 112) including a plurality of signal conductors (14; 114), a tab conductor (16; 116), and an insulation layer (18; 118) over the plurality of signal conductors (14; 114) and the tab conductor (16; 116);
**characterized by**
b] applying a plurality of bridge conductors (26; 126) on the insulation layer (18; 118), each of the plurality of bridge conductors (26; 126) being in electrical communication with the tab conductor (16; 116) through the insulation layer (18; 118) and in electrical communication with a signal conductor (14; 114) of the plurality of signal conductors (14; 114) through the insulation layer (18; 118); and
c] singulating the tab conductor (16; 116) to create a conductive tab (38; 138) which can be electrically connected to an electrical component.

9. A method as claimed in claim 8, further comprising a step prior to step b] of removing part of the insulation layer (18; 118) at the plurality of signal conductors (14; 114) and at the tab conductor (16; 116) at the locations where the electrical communication with the plurality of bridge conductors (26; 126) will be made during step b].

10. A method as claimed in claim 8 or claim 9, wherein, during step b], the plurality of bridge conductors (26; 126) is applied to the insulation layer as a printed conductive trace.

11. A method as claimed in any one of claims 8 to 10, further comprising a step b](i) following step b] and prior to step c] of applying a further insulation layer (32; 132) over the plurality of bridge conductors (26; 126).

12. A method as claimed in any one of claims 8 to 11, further comprising a step prior to step c] of removing part of the insulation layer (18; 118) at the tab conductor (16; 116) where the conductive tab (38; 138) will be created.

13. A method as claimed in any one of claims 8 to 12, wherein step b] is performed as a reel-to-reel process.

14. An electrical connector (142) for interconnecting electrical components, the electrical connector (142) comprising:
a flat flexible cable (10; 110) comprising:
a cable body (12; 112) including:
a plurality of signal conductors (14; 114);
a plurality of conductive tabs (38; 138) spaced apart from the plurality of signal conductors (14; 114); and
an insulation layer (18; 118) over at least the plurality of signal conductors (14; 114); and
**characterized by** a plurality of bridge conductors (26; 126) provided on the insulation layer (18; 118), each of the plurality of bridge conductors (26; 126) being in electrical communication with one of the plurality of conductive tabs (38; 138) through the insulation layer (18; 118) and in electrical communication with the one of the plurality of signal conductors (14; 114) through the insulation layer (18; 118).

15. A battery management system comprising an electrical connector (142) as claimed in claim 14.
